# DEMANDE DE BREVET EUROPEEN

(11) **EP 2 322 863 A1**
(43) Date de publication de la demande: **18.05.2011**
(21) Numéro de dépôt: 10191031.3
(22) Date de dépôt: 12.11.2010
(51) Int. Cl.: F24F 5/00

(54) **Pompe à chaleur thermoélectrique réversible**

(30) Priorité: 13.11.2009 FR 0957993
(71) Demandeur: Acome Société Coopérative de Production, Société Anonyme, à capital variable, 75008 Paris (FR)
(72) Inventeur: Ait Ameur, Mehdi, 50140, Romagny (FR); Cherbonnel, Hervé, 50600, Saint Hilaire (FR); Bouillaut, Désiré, 50140, Le Neufbourg (FR)
(74) Mandataire: Cabinet Plasseraud

(57) **Abrégé**

Pompe à chaleur réversible comprenant des premières et deuxièmes conduites aller et retour (11, 12, 21, 22) présentant chacune une première extrémité raccordée respectivement à un premier et un deuxième circuit d'échange de chaleur, et au moins une unité thermoélectrique (50) comprenant deux échangeurs (51, 52) ainsi que des modules thermoélectriques pour transférer de la chaleur entre les échangeurs. Les premières et deuxièmes conduites aller et retour sont rigides et supportées de manière fixe par un socle (4) pour former un châssis (10) portant des premiers et deuxièmes collecteurs aller et retour (31, 32, 41, 42) montés amovibles sur des deuxièmes extrémités (11b, 12b, 21b, 22b). Les premiers et deuxièmes collecteurs aller et retour présentent chacun un connecteur (43) pour relier de manière amovible et supporter fixement l'unité thermoélectrique, et assurent la circulation séparée de fluides dans les deux échangeurs. Une gamme de pompes à chaleur peut être réalisée ainsi.

## Description

La présente invention se rapporte à une pompe à chaleur thermoélectrique, c'est-à-dire comportant des modules thermoélectriques aussi appelés Cellules à Effet Peltier (CEP), qui permettent notamment de transférer de la chaleur d'une première face dite froide vers une deuxième face dite chaude en faisant circuler un courant électrique continu entre ces faces. Une simple inversion du courant électrique entre les faces permet d'effectuer un transfert de chaleur en sens inverse. Cette facilité d'inversion de l'échange de chaleur permet un fonctionnement réversible de la pompe à chaleur, par exemple pour rafraîchir un local d'habitation en été en évacuant vers l'extérieur de la chaleur.

Plus particulièrement, l'invention se rapporte à une pompe à chaleur réversible destinée à être raccordée :
- à un premier circuit pour échanger de la chaleur avec l'intérieur d'un local et dans lequel circule un premier fluide ;
- à un deuxième circuit pour échanger de la chaleur avec l'extérieur et dans lequel circule un deuxième fluide ; et
- à une source de courant électrique,
ladite pompe à chaleur comprenant :
- une première conduite aller et une première conduite retour présentant chacune une première extrémité destinée à être raccordée au premier circuit d'échange de chaleur, et une deuxième extrémité ;
- une deuxième conduite aller et une deuxième conduite retour présentant chacune une première extrémité destinée à être raccordée au deuxième circuit d'échange de chaleur, et une deuxième extrémité ;
- au moins une unité thermoélectrique de transfert de chaleur comprenant un premier et un deuxième échangeur ainsi qu'un nombre prédéterminé de modules thermoélectriques adaptés pour transférer de la chaleur entre les premier et deuxième échangeurs ;
- une unité d'alimentation électrique adaptée pour alimenter ladite au moins une unité thermoélectrique à partir de la source de courant électrique ;
- un boîtier comprenant un châssis et des panneaux d'habillage à l'intérieur duquel sont logés les éléments de ladite pompe à chaleur.

Le principe consistant à utiliser des modules thermoélectriques ou CEP pour réaliser un système de pompe à chaleur pour le chauffage de locaux d'habitation ou professionnels, est connu, par exemple du document FR2879728 au nom du demandeur, ou du document EP1486743 Al. En effet, l'utilisation de modules thermoélectriques apparaît séduisante pour réaliser un appareil réversible c'est-à-dire pouvant fonctionner de manière inversée en rafraîchissant les locaux. Néanmoins, il n'y a à ce jour pas d'offre concrète d'appareil de ce type. Il est à noter que les deux documents ci-dessus ne représentent les pompes à chaleur en question que de manière très schématique et partielle. En effet, par pompe à chaleur il faut comprendre un appareil directement installable dans un bâtiment moyennant le raccordement, d'une part, à un système de chauffage central existant ou neuf formant le premier circuit, comme par exemple un système de chauffage par plancher, et, d'autre part à un système d'échange de chaleur avec le milieu extérieur formant le deuxième circuit. Le système d'échange avec l'extérieur peut être entre autres de type réseau ou cuve enterrée dans le sol, ou système d'échange avec l'air ou une masse d'eau.

Cette absence de proposition commerciale de pompe à chaleur thermoélectrique peut s'expliquer par différentes raisons. Les applications actuelles des modules thermoélectriques concernent essentiellement la production de froid pour les appareils électroniques ou des réfrigérateurs de voyage, c'est-à-dire des applications où la puissance d'échange de chaleur est très inférieure à celle nécessaire pour un chauffage domestique qui fournit généralement une puissance d'apport de chaleur de quelques kilowatts à 25 Kw.

Un autre facteur limitant est le coefficient de performance (COP) maximal théorique que l'on peut atteindre actuellement avec des CEP, mais encore plus le COP réel qui se dégrade sensiblement quand les conditions de fonctionnement changent et notamment les températures des premier et deuxième fluides. Aussi, il n'est pas envisagé ce jour d'atteindre un COP supérieur à 4, contrairement aux dernières les pompes à chaleur traditionnelles qui rencontrent un grand succès commercial. Pour rappel, ces pompes à chaleur traditionnelle utilisent un circuit fermé dans lequel un fluide frigorigène comme un hydrofluorocarbure subit un cycle de compression/détente entre un condenseur et un évaporateur.

L'obtention d'un COP réel économiquement et énergétiquement intéressant implique de mettre au point un appareil relativement complexe, dont le fonctionnement s'adapte aux conditions intérieures et extérieures, et dans lequel circulent des fluides permettant un échange efficace de chaleur, comme l'eau.

Il s'agit donc d'un appareil s'apparentant plus à une chaudière de chauffage central, qu'à un radiateur destiné à chauffer une seule pièce. Par exemple, le document FR2028203 propose un appareil à cellules Peltier de type radiateur qui est relié à l'installation de chauffage à eau chaude et alimenté électriquement. L'échange de chaleur avec la pièce se fait directement par contact de l'air avec une plaque. L'échange de chaleur entre les cellules Peltier et l'air est bien moins efficace qu'avec un fluide hydraulique, d'autant plus que la température de l'air directement réinjectée dans la pièce doit rester dans une plage compatible avec le confort des personnes.

Le coût unitaire des modules thermoélectriques, mais aussi le coût de mise au point d'un appareil utilisant ces modules, est également un frein à l'apparition de pompes à chaleur thermoélectrique.

La présente invention a pour but de proposer une structure de pompe à chaleur thermoélectrique qui permet de produire industriellement ce type d'appareil à un coût économiquement acceptable et qui, de préférence, permet une meilleure utilisation des modules thermoélectriques.

A cet effet, la présente invention a pour objet une pompe à chaleur du type précité, caractérisée en ce que les premières et deuxièmes conduites aller et retour sont rigides et reliées de manière fixe à un socle pour former au moins une partie du châssis, ledit châssis portant des premiers et deuxièmes collecteurs aller et retour qui sont montés de manière amovible respectivement sur les deuxièmes extrémités des premières et deuxièmes conduites aller et retour, lesdits premiers et deuxièmes collecteurs aller et retour présentant chacun au moins un connecteur adapté pour relier de manière amovible et supporter fixement ladite au moins une unité thermoélectrique de transfert de chaleur, les premiers collecteurs aller et retour assurant la circulation du premier fluide dans le premier échangeur de ladite au moins une unité et les deuxièmes collecteurs aller et retour assurant la circulation séparée du deuxième fluide dans le deuxième échangeur.

La pompe à chaleur ainsi réalisée représente un ensemble standard constitué par le châssis qui, outre les éléments prévus dans la revendication 1, peut également comprendre des accélérateurs pour la circulation des premier et deuxième fluides, ainsi que des détendeurs pour réguler leur pression. Ce châssis comprenant le socle de l'appareil, reçoit de manière amovible une ou plusieurs unités thermoélectriques. Chaque unité forme un sous-ensemble standard incluant les modules thermoélectriques et les échangeurs qui sont associés et dimensionnés pour ces modules. Cette structure modulaire de l'appareil permet de réaliser des pompes à chaleur de différentes puissances à partir de sous-ensembles identiques, et donc de réaliser des économies d'échelle et une rationalisation de la production.

Il est à noter que cette conception est foncièrement différente des pompes à chaleur classiques dans laquelle la capacité d'échange de chaleur est déterminée par le circuit de fluide frigorigène pour lequel une modification de la puissance d'échange implique une nouvelle conception du compresseur, du détendeur et de l'évaporateur, ainsi que de leur châssis.

On notera également que le montage amovible des collecteurs sur les deuxièmes extrémités des conduites du châssis assure une double fonction, à savoir une fonction de mise en communication des fluides avec les unités thermoélectriques et une fonction de support mécanique de ces unités.

L'appareil permet d'accueillir un nombre variable d'unités thermoélectriques sans que d'autres éléments aient à être modifiés, sauf éventuellement les dimensions du boîtier selon l'espace libre prévu dans celui-ci, et éventuellement la puissance que peut délivrer l'unité d'alimentation électrique. Mais, là encore, il est possible de prévoir que des éléments standards soient multipliés, comme par exemple le nombre de transformateurs.

Comme il ressortira par la suite, le fait d'avoir plusieurs unités thermoélectriques montées selon la structure définie ci-dessus, s'avère particulièrement intéressant pour une meilleure utilisation des éléments thermoélectriques, et par conséquent une amélioration du coefficient de performance (COP) dans les conditions réelles d'utilisation de la pompe à chaleur.

Dans des modes de réalisation préférés, on a recours en outre à l'une ou l'autre des dispositions suivantes.

Chacun des connecteurs des premiers et deuxièmes collecteurs aller et retour est portés par un élément modulaire identique à travers lequel circule l'un des premier et deuxième fluides, la distance séparant les connecteurs respectifs de deux éléments modulaires assemblés étant supérieure à l'espacement nécessaire entre deux unités thermoélectriques. L'utilisation d'éléments modulaires permet encore de rationnaliser la production en utilisant des éléments identiques pour chacun des quatre collecteurs et formant l'essentiel de leur structure. Grâce à cette disposition, il n'est pas nécessaire de prévoir la fabrication de différents types de connecteurs présentant un nombre variable de connecteurs en fonction du nombre de modules thermoélectriques à inclure dans la pompe à chaleur. Ceci simplifie la production, même si chacun des quatre collecteurs pourraient être une pièce identique pour un nombre d'unités donné.

Les deuxièmes extrémités de chacune des premières et deuxièmes conduites aller et retour, sont agencées à des hauteurs différentes par rapport a un plan de référence de manière à ce que ladite au moins une unité thermoélectrique relié aux deuxièmes extrémités par des collecteurs identiques, soit parallèle audit plan de référence. En ajustant la hauteur des deuxièmes extrémités des conduites pour tenir compte du décalage entre les entrées et sorties de fluides des échangeurs d'une unité, on réalise un châssis qui assure le positionnement correct des connecteurs des collecteurs identiques, éventuellement formés d'éléments modulaires, sans qu'il soit nécessaire de prévoir des entretoises pour obtenir un alignement correct.

Le plan de référence est déterminé de manière à ce que ladite au moins une unité thermoélectrique présente une face supérieure globalement inclinée d'un angle compris entre 30 et 70 degrés par rapport à l'horizontale définie par le socle. Ainsi, l'eau de condensation qui peut se former sur la surface des échangeurs du fait du fonctionnement réversible des unités thermoélectriques, est évacuée par gravité.

Les deuxièmes extrémités des premières et deuxièmes conduites aller et retour présentent une ouverture orientée vers le haut, les premier et deuxième collecteurs aller et retour s'étendant verticalement à partir de chacune de ces deuxièmes extrémités. Cet agencement des conduites fait qu'elles forment un support solide, près du socle, dont la résistance mécanique n'a pas à être surdimensionnée pour un nombre maximal d'unités thermoélectriques, notamment par rapport à la possibilité de collecteurs s'étendant horizontalement qui créerait un effort de flexion important. Un nombre d'unités thermoélectriques plus ou moins important peut être agencé dans le boîtier, soit en prévoyant un espace libre suffisant au-dessus du châssis, soit en adaptant la hauteur du boîtier au nombre d'unités. Cette dernière solution nécessite bien entendu des panneaux latéraux et des montants de longueur différente selon le nombre d'unités. Néanmoins il s'agit d'éléments standards n'ayant pas à supporter des contraintes mécaniques importantes et pouvant être coupés à longueur.

Les premier et deuxième échangeurs de ladite au moins une unité thermoélectrique sont sensiblement identiques, de forme globalement parallélépipédique, et présentent des entrées et sorties de fluide sur des faces latérales opposées. Les entrées et sorties agencées de manière opposée permettent un bon maintien des unités en les agençant entre les connecteurs, qui sont eux à disposer aux quatre coins d'un rectangle.

Ladite au moins une unité thermoélectrique comprend un isolant disposé entre les premier et deuxième échangeurs, et présentant des fenêtres de dimensions correspondant aux éléments thermoélectriques, lesdits éléments thermoélectriques étant en contact direct avec les premier et les deuxième échangeurs à travers lesdites fenêtres. Le fait de prévoir un tel isolant limite les transferts de chaleur par rayonnement entre les premier et deuxième échangeurs qui tendraient à rapprocher la température des premier et deuxième fluides. Un avantage supplémentaire de cet isolant est qu'il assure un positionnement relatif entre les modules thermoélectriques. Ceci facilite la fabrication mais aussi la capacité d'encaisser des chocs pour les unités thermoélectriques assemblés.

L'unité d'alimentation électrique est placée dans la partie haute du boîtier, au-dessus de ladite au moins une unité thermoélectrique. Cette disposition évite que d'éventuelles fuites de fluides viennent interférer avec les circuits électriques, mais il faut noter aussi qu'elle n'est pas pénalisante pour la structure de la pompe à chaleur. En effet le poids de l'alimentation électrique ne nécessite pas une structure au support aussi rigide et solide que les circuits de circulation de fluide ou de transfert de chaleur. La connexion à des unités thermoélectriques plus ou moins distants est aisée avec des câbles souples.

Une pluralité d'unités thermoélectriques identiques est supportée fixement par les premier et deuxième collecteurs aller et retour. Ainsi, la fabrication des pompes à chaleur peut être rationalisée en utilisant un unique type d'unité d'échange de chaleur montée en plus ou moins grand nombre selon la puissance de chauffage ou la capacité de rafraîchissement maximale que doit fournir l'appareil.

L'unité d'alimentation électrique comporte une pluralité de fiches électriques susceptibles de délivrer chacune un courant d'alimentation pour une unité thermoélectrique, le nombre de fiches électriques étant égal au nombre maximal d'unités thermoélectriques susceptibles d'être reçues dans le boîtier. Chacune desdites unités thermoélectriques présente alors de préférence une prise et ainsi, la connexion électrique d'une unité supplémentaire peut se faire par simple engagement d'une prise électrique.

L'unité d'alimentation électrique comprend un dispositif de commande adapté pour commander sélectivement la délivrance d'un courant d'alimentation à des unités thermoélectriques déterminées parmi la pluralité d'unités. Cette disposition permet d'optimiser le fonctionnement de la pompe à chaleur pour obtenir un bon coefficient opérationnel (COP) même si le besoin d'échange de chaleur au premier circuit est bien inférieur à la capacité maximale d'échange de chaleur pour les conditions de fonctionnement et le nombre de modules thermoélectriques.

Au moins une paire de connecteurs des premiers et deuxièmes collecteurs comporte une moto-vanne pour fermer sélectivement la circulation des premier et deuxième fluides dans une unité thermoélectrique déterminée. Le dispositif de commande est alors de préférence adapté pour commander la fermeture des moto-vannes des unités thermoélectriques non alimentés électriquement. Ceci toujours dans le but d'améliorer le coefficient opérationnel à puissance réduite.

La présente invention se rapporte également à une gamme de pompes à chaleur réversibles telle que définie ci-dessus, dans laquelle chaque modèle de la gamme comprend un châssis et au moins une unité thermoélectrique identiques, le nombre d'unités thermoélectriques étant différent d'un modèle à l'autre de la gamme, et de préférence compris entre trois et douze unités. La puissance thermique maximale d'une unité thermoélectrique est typiquement de l'ordre de 500 W pour couvrir une gamme de puissances maximales de chauffage comprise entre 1,5 Kw et 6 Kw. En effet, il apparait que ce type de pompes à chaleur est particulièrement avantageux pour les faibles puissances où les pompes à chaleur thermodynamiques rencontrent des problèmes d'optimisation et de dimensionnement des compresseurs. Mais la puissance unitaire peut être plus importante.

Une telle gamme d'appareils comporte un grand nombre d'éléments standard permettant de réduire le coût de fabrication. Mais cette gamme permet aussi d'ajuster la puissance d'échange thermique de manière précise par rapport aux besoins de l'utilisateur. Ceci permet des économies d'énergie en proposant un appareil dont le fonctionnement sera plus souvent plus proche du coefficient optimum d'utilisation.

D'autres caractéristiques et avantages apparaîtront au cours de la description qui va suivre, donnée à titre d'exemple non limitatif, en regard des dessins schématiques dans lesquels :
- la figure 1 est une vue de face partiellement écorchée d'une pompe à chaleur réversible selon l'invention et comprenant trois unités thermoélectriques ;
- la figure 2 est une vue de côté arrachée de la pompe à chaleur de la figure 1 ;
- la figure 3 est une vue de derrière arrachée de la pompe à chaleur de la figure 1 ; et
- la figure 4 est une vue en perspective d'une partie d'une unité thermoélectrique de la figure 1.

Sur les différentes figures, les mêmes références désignent des éléments identiques ou similaires.

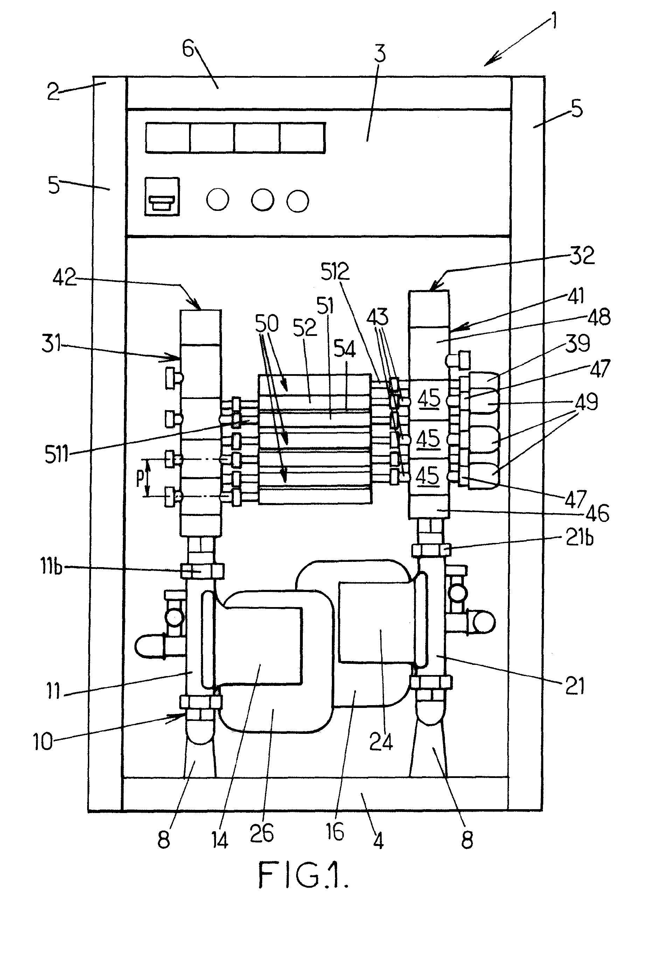

A la figure 1, est représentée une pompe à chaleur 1 se présentant sous forme d'un boîtier 2 avec en façade un panneau de commande 3.

Le boîtier 2 comprend un socle 4 à partir duquel s'étendent des montants verticaux 5 formés par exemple par des cornières métalliques et reliés à leur sommet par des entretoises 6. Les côtés du boîtier 2 sont habillés par des panneaux non représentés, formés par exemple de plaques métalliques.

Pour remplir sa fonction, le socle 4 est un élément rigide et à même de supporter le poids de l'ensemble de la pompe à chaleur 1. Il peut être fixé directement au sol, ou par l'intermédiaire d'un piètement ou d'une console.

Il s'agit d'une pompe à chaleur destinée à chauffer des locaux d'habitation ou professionnels, mais aussi à rafraîchir ces locaux grâce à l'utilisation de Cellules à Effet Peltier (CEP) ou modules thermoélectriques comme cela sera détaillé ci-après. Les locaux d'habitation en question sont typiquement des habitations individuelles allant d'un appartement de quelques pièces à une maison individuelle. La puissance est donc typiquement prévue entre 1,5 et 6 kilowatts de puissance de chauffage maximale, sans que cette dernière valeur constitue une limite supérieure.

Pour son fonctionnement, la pompe à chaleur nécessite d'être raccordée à une source de courant électrique, comme par exemple un réseau de distribution électrique délivrant une tension alternative de 240 Volts à 50 Hertz. La pompe à chaleur doit être raccordée à un premier circuit d'échange de chaleur avec l'intérieur du local, afin de chauffer ou rafraîchir celui-ci. Ce premier circuit non représenté peut être de tous types connus, et notamment un circuit hydraulique comprenant des planchers chauffants ou des radiateurs répartis dans l'habitation. Il s'agit alors d'un circuit hydraulique comprenant donc un premier fluide constitué essentiellement d'eau qui circule en boucle fermée.

La pompe à chaleur 1 doit également être reliée à un deuxième circuit pour échanger de la chaleur avec l'extérieur, et plus particulièrement prélever de la chaleur au milieu extérieur afin de chauffer l'habitation, ou évacuer de la chaleur vers le milieu extérieur lorsqu'elle fonctionne en mode rafraîchissement ou climatisation. Ce deuxième circuit non représenté peut être de types assez variés. Il peut s'agir d'un circuit hydraulique fermé comprenant un réseau ou une cuve enterrée plus ou moins profondément dans le sol, ou immergée dans une masse d'eau. Il peut encore s'agir d'un système dans lequel le deuxième fluide soit toujours de l'eau, mais échangeant la chaleur avec l'air extérieur. Il est également envisageable pour le deuxième circuit de prévoir un système aspirant et rejetant l'air extérieur qui constituerait le deuxième fluide. Toutefois le mode de réalisation représenté correspond à une pompe à chaleur destinée à fonctionner avec des premier et deuxième fluides hydrauliques.

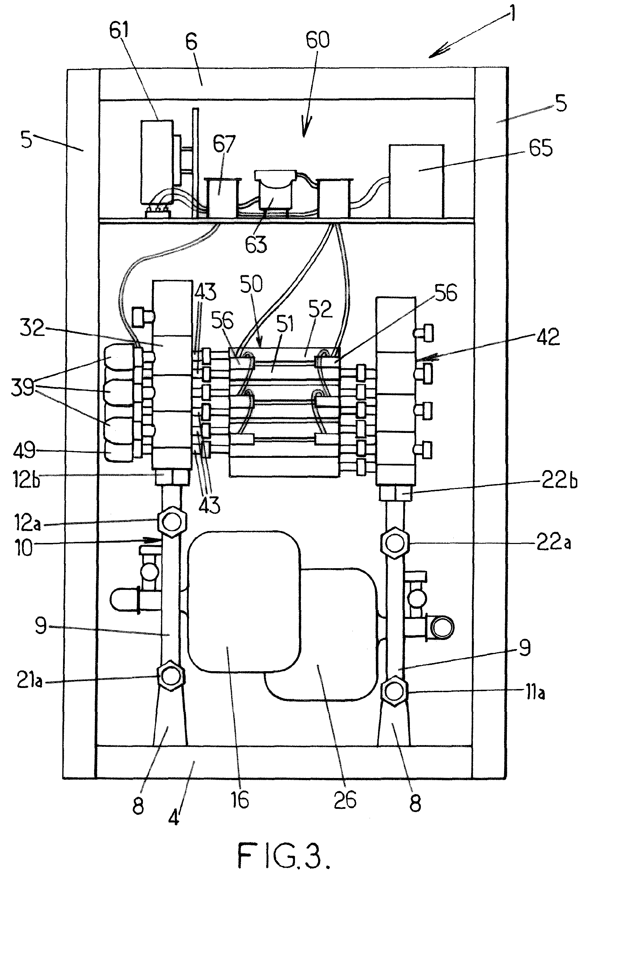

La pompe à chaleur comprend une première conduite aller 11, une première conduite retour 12 qui présentent chacune une première extrémité (11a, 12a) visibles à la figure 3. Ces premières extrémités (11a, 12a) sont destinées à être reliées respectivement à l'arrivée et au départ du premier circuit d'échange avec le local d'habitation. Ce raccordement est effectué de préférence de manière amovible avec des bagues filetées schématiquement représentées. Le boîtier 2 comprend également une deuxième conduite aller 21, une deuxième conduite retour 22 présentant de manière analogue des premières extrémités (21a, 22a) destinées à être reliées au deuxième circuit prévu pour l'échange de chaleur avec l'extérieur. Les conduites présentent des deuxièmes extrémités (11b, 12b, 21b, 22b).

Les conduites (11, 12, 21, 22) sont réalisées à partir de tubes relativement rigides coudés ou raccordés entre eux par des éléments standard du domaine du chauffage central. Il s'agit par exemple de tubes en acier d'un diamètre compris entre 30 et 60 mm.

Dans ce mode de réalisation préférentiel, les deuxièmes extrémités (11b, 12b, 21b, 22b) présentent des débouchés disposés aux coins d'un rectangle et orientés de manière parallèle vers le haut. Il est toutefois envisageable que le débouché de ces deuxièmes extrémités soit orienté différemment, notamment de manière parallèle mais à l'horizontal, ou encore vers le bas. Ces deuxièmes extrémités sont munies de bagues permettant un raccordement amovible.

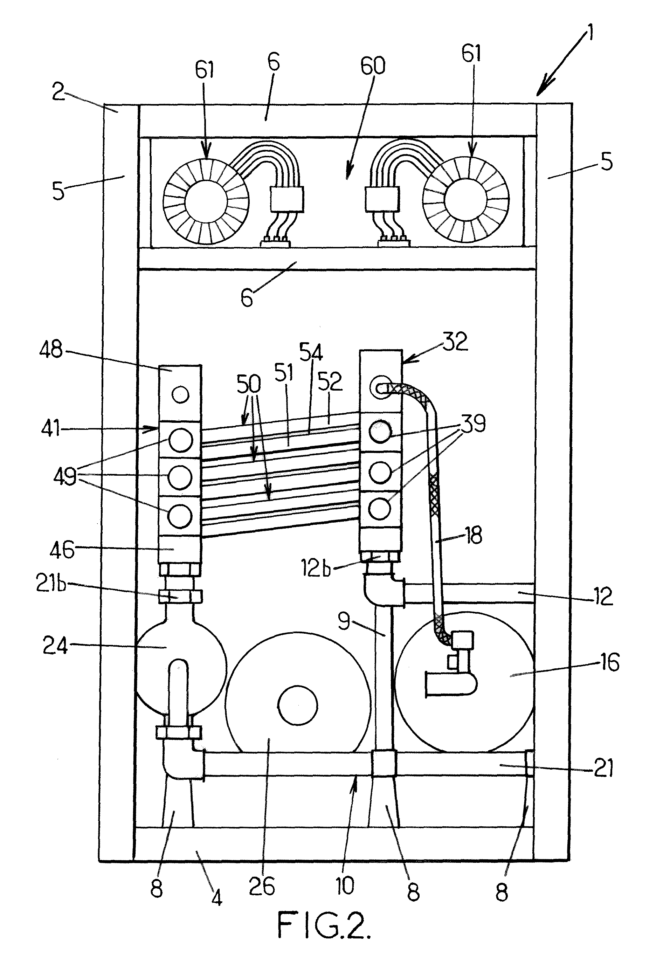

Les conduites (11, 12, 21, 22) sont supportées de manière fixe et solide par rapport au socle 4 par l'intermédiaire de supports rigides. Ces supports comprennent des supports 8 s'étendant du socle 4 aux première et deuxième conduites aller (11, 21), et des supports 9 visibles aux figures 2 et 3 qui s'étendent entre les conduites (11, 22 ; 12, 21). Les supports (8, 9) peuvent être réalisés de diverses façons, à partir d'éléments standard ou de pièces moulées. De même, la fixation de ces supports (8, 9) aux conduites peut être réalisée de différentes manières, fixation mécanique ou soudage. Le fait important est que les deuxièmes extrémités (11b, 12b, 21b, 22b) des conduites aient une position et une orientation relativement fixes et rigides entre elles, ainsi que par rapport au socle 4.

Les première et deuxième conduites aller et retour (11, 12, 21, 22) forment donc avec le socle 4 et les supports (8, 9) un châssis 10 sur lequel différents éléments peuvent être montés. Par exemple, on notera dans le mode de réalisation représenté que la première conduite aller 11 et la deuxième conduite aller 21 supportent chacune un moteur (14 ; 24) de type bien connu pour mettre en circulation les premier et deuxième fluides dans leur circuit respectif. Le châssis 10 sert également de support pour des vases d'expansion (16, 26) permettant de réguler la pression dans les premier et deuxième circuits.

Les éléments décrits ci-dessus, et en particulier le châssis 10 peuvent constituer un sous-ensemble standard, identique pour différents modèles d'une gamme de pompes à chaleur. En effet, la capacité des circulateurs et des vases d'expansion ne varie pas nécessairement de manière importante d'un modèle à l'autre.

Chacune des deuxièmes extrémités (11b, 12b, 21b, 22b) porte un collecteur, à savoir un premier collecteur aller 31 pour la première conduite aller 11, un premier collecteur retour 32 pour la première conduite retour 12, un deuxième collecteur aller 41 pour la deuxième conduite aller 21 et un deuxième collecteur retour 42 pour la deuxième conduite retour 22.

Chacun des collecteurs (31 ; 32 ; 41 ; 42) est un organe tubulaire qui est en communication fluidique avec le débouché des conduites (11, 12, 21, 22). Ils comportent chacun un nombre déterminé de connecteurs indiqués par les références 43 pour le deuxième collecteur aller 41 visible sur la figure 1. Les connecteurs 43 doivent assurer une fixation mécanique et une communication fluidique entre l'intérieur du collecteur 41 et une conduite aval. La fixation mécanique est préférentiellement amovible et réalisée, par exemple, par une portion filetée.

Dans le mode de réalisation préférentiel représenté, les collecteurs (31, 32, 41, 42) sont rectilignes et s'étendent donc verticalement dans le prolongement des deuxièmes extrémités des conduites. Les connecteurs 43 s'étendent dans une direction perpendiculaire à l'axe longitudinal du collecteur correspondant 41, et présentent une section de passage sensiblement inférieure à la section intérieure du collecteur. Les connecteurs 43 sont régulièrement espaces d'un pas prédéterminé p indiqué sur la figure 1 en référence au premier collecteur aller 31. Il est à noter que les quatre collecteurs (31, 32, 41, 42) et leurs connecteurs 43 sont identiques, de sorte que les connecteurs sont régulièrement répartis verticalement à des niveaux déterminés par la position verticale des deuxièmes extrémités (11b, 12b, 21b, 22b) des conduites.

De manière avantageuse pour la modularité de construction et la réalisation d'une gamme d'appareils de puissances différentes, chacun des collecteurs comprend des éléments modulaires identiques 45 formant une portion longitudinale du collecteur et portant un connecteur 43. Ces éléments modulaires 45 réalisés par exemple en matière plastique, peuvent être raccordés directement entre eux de manière étanche par une liaison quart de tour.

Chacun des éléments modulaires 45 comporte une vanne adaptée pour fermer la communication fluidique avec le connecteur 43 correspondant, sans toutefois interrompre la circulation longitudinale à travers cet élément. Sur les figures, seules les sorties 47 comportant l'axe de commande de ces vannes, sont visibles.

Chaque collecteur comprend une pièce de raccordement inférieure 46 et une tête 48 qui sert d'une part à fermer l'extrémité longitudinale supérieure de chacun des collecteurs et d'autre part l'un des premier ou deuxième circuit au vase d'expansion correspondant (16 ; 26) à l'aide d'un flexible, comme le flexible 28 représenté uniquement à la figure 2.

Des actionneurs électromécaniques sont montés sur les commandes de vanne de certains des connecteurs pour former des moto-vannes (49, 39). Plus précisément, chacun des connecteurs 43 du deuxième collecteur aller 41 comporte une moto-vanne 49, ce qui permet de refermer sélectivement toute ou partie de ces connecteurs 43 du deuxième circuit. De même, comme cela est mieux visible aux figures 2 et 3, le premier collecteur retour 32 du deuxième circuit comporte des moto-vannes 39 susceptibles de fermer sélectivement chacun de ses connecteurs.

Cette structure des collecteurs (31, 32, 41, 42) à base d'éléments modulaires 45 n'est qu'une possibilité de réalisation. Il est parfaitement possible d'utiliser des collecteurs monoblocs s'étendant jusqu'au niveau du panneau de commande 3 et présentant un nombre supérieur de connecteurs.

Entre les collecteurs (31, 32, 41, 42) sont agencées trois unités thermoélectriques de transfert de chaleur 50. Ces trois unités 50 sont identiques selon le mode de réalisation préféré. Ainsi, chaque unité thermoélectrique constitue un deuxième élément standard. En référence à l'unité thermoélectrique supérieure 50, celle-ci comprend un premier échangeur 51 et un deuxième échangeur 52 situé au-dessus du premier.

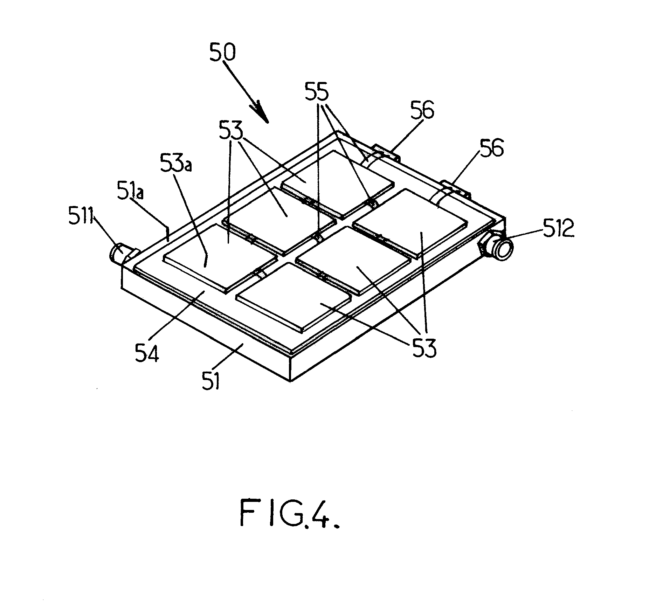

Comme cela est mieux visible à la figure 4 où l'unité thermoélectrique 50 est représentée en perspective sans le deuxième échangeur supérieur 52, le premier échangeur 51 se présente sous forme d'un boîtier parallélépipédique dans lequel des canaux sont ménagés pour assurer la circulation du premier fluide et assurer un échange avec la face supérieure plane 51a. Le premier échangeur 51 présente une entrée de fluide 511 située du côté gauche et en avant de l'unité thermoélectrique 50, de sorte que cette entrée 511 est raccordée à un connecteur du premier collecteur aller 31. La sortie 512 du premier échangeur 51 est agencée de manière opposée, c'est-à-dire du côté droit et en arrière pour être reliée au connecteur du premier collecteur retour 32, situé au même niveau.

Les premiers échangeurs 51 de chaque unité thermoélectrique 50 sont tous identiques et agencés de la même manière, de sorte qu'ils assurent chacun une communication entre une paire de connecteurs des premiers collecteurs aller et retour (31, 32). La fermeture de l'un de la paire de connecteurs reliés au premier échangeur 51 à l'aide de la moto-vanne 39, permet d'arrêter la circulation du premier fluide dans celui-ci.

En mode chauffage, le premier fluide qui circule dans le premier échangeur 51 sert à apporter de la chaleur au local via le premier circuit. Il s'agit typiquement d'eau à une température de l'ordre de 50°, la face supérieure 51a du premier échangeur constitue alors la face chaude de l'unité thermoélectrique d'échange de chaleur 50.

Le deuxième échangeur 52, non représenté sur la figure 4, est en tout point identique mais agencé avec sa face d'échange orientée vers le bas. L'entrée du deuxième échangeur 52 est donc située à droite et en avant, et reliée au deuxième collecteur aller 41, tandis que sa sortie agencée à gauche et en arrière est reliée au deuxième collecteur retour 42. De même que pour les premiers collecteurs 51, la circulation du deuxième fluide peut être interrompue sélectivement dans chacun des deuxièmes échangeurs 52 à l'aide des moto-vannes 49 du deuxième collecteur aller 41.

Le deuxième échangeur 52 assure la communication entre les deuxièmes conduites aller et retour (21, 22) connectées au deuxième circuit servant à prélever de la chaleur à l'extérieur en mode chauffage. Il peut s'agir par exemple d'eau à une température de l'ordre de 10° grâce à la chaleur prélevée dans le sol par un réseau enterré. La face inférieure du deuxième échangeur 52 constitue donc une face froide de l'unité thermoélectrique 50 en mode chauffage.

Les échangeurs 51 et 52 sont conçus pour faciliter les échanges de chaleur entre le fluide, ici de l'eau, et leur paroi en contact avec les modules thermoélectriques. Par contre, les autres parois peuvent être isolées pour éviter des déperditions de chaleur dans le boîtier 2. Bien entendu, les conduites et collecteurs aller et retour (11, 12, 21, 22, 31, 32, 41, 42) n'ont pas de fonction d'échangeur de chaleur. Au contraire, pour l'amélioration du COP, on cherchera à limiter les échanges thermiques entre ces conduites.

L'unité thermoélectrique 50 comprend des modules thermoélectriques ou Cellules à Effet Peltier (CEP) 53 représentés au nombre de six à titre d'illustration. Il s'agit de CEP standard présentant des surfaces d'échange planes, comme cela est visible pour la face supérieure 53a, qui sont mises en contact thermique avec les surfaces d'échange 51a des premier et deuxième échangeurs (51, 52). Les CEP sont destinées à être alimentées en courant continu. Le transfert de chaleur s'effectue d'une face vers l'autre selon la polarité de la tension appliquée. Une simple inversion de la polarité permet de passer d'un mode chauffage à un mode rafraichissement. En mode chauffage, la tension appliquée doit présenter une polarité pour que la face inférieure des CEP en contact avec la face 51a du premier échangeur soit la face chaude de la cellule et que la face supérieure 53a en contact avec le deuxième échangeur 52 corresponde à la face froide. A titre d'indication en mode chauffage, la face chaude des cellules a une température d'environ 60 °, tandis que la face froide 53a a une température proche de 0°. Les cellules 53 sont reliées entre elles par des connexions électriques selon un montage série ou parallèle, les fils électriques 55 représentés étant une simple indication schématique.

L'ensemble des connexions aux CEP est regroupé vers une ou deux prises 56 situées à l'arrière du premier échangeur. Le fait de prévoir des prises 56 facilite bien entendu la fabrication de la pompe à chaleur, mais aussi la maintenance et le remplacement d'une unité thermoélectrique. Cela facilite également une éventuelle opération de modification d'une pompe à chaleur existante pour augmenter la puissance nominale de celle-ci.

On notera également à la figure 4 la présence d'un isolant 54 disposé entre les faces d'échange des premier et deuxième échangeurs (51, 52) et entourant chacune des CEP 53. Cet isolant 54 se présente ici sous forme d'une feuille en matériau isolant qui peut être plus ou moins souple et d'une épaisseur variant de quelques millimètres à la hauteur des CEP. L'isolant 54 présente des fenêtres de dimensions correspondantes au CEP. L'isolant 54 évite un échange de chaleur direct entre le premier et le deuxième échangeurs (51, 52) qui irait dans le sens inverse à celui créé par les CEP. Outre son rôle d'isolant, la feuille 54 assure une immobilisation relative entre les CEP 53, leur disposition les unes par rapport aux autres pouvant être importantes pour assurer un échange optimisé et homogène entre les premier et deuxième échangeurs (51, 52). La pression de contact exercée par les échangeurs (51, 52) sur les CEP permet une immobilisation de l'ensemble tout à fait satisfaisante, mais il est également possible de prévoir une immobilisation de l'isolant 54 par rapport à l'un ou l'autre des échangeurs, par exemple par collage sur la face supérieure 51a du premier échangeur.

Bien que non représenté, il peut être également avantageux d'isoler thermiquement l'ensemble d'une unité thermoélectrique 50 en recouvrant les faces extérieures des échangeurs (51, 52) d'un isolant. Ceci pour éviter les déperditions de chaleur avec l'air entourant la pompe à chaleur, mais aussi pour limiter la formation d'eau de condensation.

Concernant l'évacuation des condensats qui se forme sur l'une ou l'autre face des unités thermoélectriques, selon le mode de fonctionnement, il faut noter que la disposition des deuxièmes extrémités (11b, 12b, 21b, 22b) des conduites à des hauteurs différentes et l'utilisation de collecteurs (31, 32, 41, 42) identiques permet de positionner avantageusement les unités thermoélectriques 50. En effet, ces variations de hauteur permettent de définir un plan de référence incliné, auquel sont parallèles les faces principales des échangeurs (51, 52) parallélépipédiques. L'angle d'inclinaison est de préférence compris entre 30 et 70° pour fournir un compromis satisfaisant entre la capacité d'évacuation des condensats et l'encombrement de l'ensemble.

Une unité d'alimentation électrique 60 de la pompe à chaleur 1 est située dans la partie haute du boîtier 2, c'est-à-dire à l'abri des condensats et éventuelles fuites, comme cela est mieux visible aux figures 2 et 3. L'unité d'alimentation électrique 60 comporte au moins un dispositif 61 permettant de transformer la tension alternative du réseau en tension adaptée pour l'alimentation des unités thermoélectriques 50. Comme dans le mode de réalisation représenté, l'alimentation 60 peut comprendre deux, ou plus, dispositifs de transformation de tension identiques à 61 pour permettre la fabrication d'une large gamme de puissance de pompe à chaleur en limitant le nombre de composants différents nécessaires. Par exemple, pour un nombre limité d'unités thermoélectriques 50, le nombre de trois représenté ici n'illustre aucun nombre préférentiel minimum, il est possible de ne prévoir qu'un seul dispositif de transformation de tension 61, et de doubler celui-ci pour des nombres d'unités thermoélectriques 50 plus importants, ce nombre pouvant aller jusqu'à douze voire vingt-quatre.

Les dispositifs de transformation de tension 61 alimentent un bornier qui comprend de préférence un nombre de fiches électriques égal au nombre maximum d'unités thermoélectriques 50 pouvant être logés dans le boîtier 2. L'unité d'alimentation électrique 60 comporte également un dispositif de commande 65 pouvant comprendre des circuits électroniques plus ou moins complexes selon le fonctionnement plus ou moins optimisé que l'on veut obtenir de la pompe à chaleur, mais aussi de l'ensemble de l'installation. Comme cela est connu, ce dispositif de commande 65 peut prendre en compte des paramètres comme les températures intérieure/extérieure, les températures des premier et deuxième fluides à l'entrée et/ou à leur sortie de la pompe à chaleur 1 pour déclencher ou non son fonctionnement.

Ce fonctionnement peut être en mode chauffage en apportant au premier fluide la chaleur prélevée au deuxième fluide au niveau des unités thermoélectriques 50, plus la chaleur dégagée par les CEP 53 elles-mêmes par effet Joule. Une simple inversion de la tension d'alimentation de ces mêmes CEP permet de passer à un fonctionnement en mode rafraîchissement dans lequel les CEP prélèvent de la chaleur au premier fluide pour la transférer vers le deuxième fluide qui est ensuite refroidi ou dilué à l'extérieur. Cette inversion peut être réalisée aisément à l'aide de commutateurs 67 pilotés par le dispositif de commande 65 et interposés entre le dispositif de transformation de 61 et le bornier 63.

Le dispositif de commande 65 permet aussi avantageusement de fermer ou ouvrir les moto-vannes (39, 49). Combinée à l'alimentation électrique sélective des unités thermoélectriques 50, cette disposition permet de rendre complètement inopérante une, ou plusieurs, unités 50. Ceci soit parce que l'unité thermoélectrique est défaillante, soit dans le but d'optimiser le fonctionnement des autres.

Comme on l'aura compris, la structure modulaire de la pompe à chaleur permet de réaliser toute une gamme d'appareils avec un minimum de sous-ensembles différents. En particulier, un châssis unique 10 peut être utilisé pour l'ensemble de la gamme étant donné qu'il est aisé de concevoir celui-ci pour recevoir un nombre très variable d'unités thermoélectriques, par exemple de trois à vingt-quatre. Pour le boîtier 2, il peut s'agir d'un seul boîtier, mais il est préférable d'en prévoir deux par exemple un premier boîtier pour un nombre d'unités thermoélectriques 50 compris entre trois et neuf, et un deuxième boîtier pour un nombre compris entre douze et vingt-quatre, cet élément ne représentant aucune difficulté de production. L'unité d'alimentation électrique 60 peut elle aussi être standard pour l'ensemble de la gamme, seul le nombre des éléments les plus onéreux, en particulier du dispositif de transformation de tension 61, pouvant être réduit dans les modèles de moindre puissance.

La présence d'une pluralité d'unités thermoélectriques 50 a aussi des avantages en termes de fiabilité de fonctionnement. En effet, une pluralité d'unités thermoélectriques 50 permet d'assurer un fonctionnement à une puissance quelque peu réduite de la pompe à chaleur. Il faut noter que l'utilisation de CEP pour des applications de chauffage domestique, c'est-à-dire à des puissances bien plus importantes que celle des applications courantes des CEP jusqu'à présent, peut faire apparaître des problèmes de fiabilité et de résistance à des conditions particulières de fonctionnement. La défaillance d'une seule CEP peut éventuellement mettre hors service l'ensemble de l'unité. Dans ce cas, le caractère modulaire présente encore un avantage pour la réparation.

Mais outre ces avantages, la pluralité d'unités thermoélectriques 50 combinées avec la possibilité de fermeture sélective de circulation des premier et deuxième fluides dans celles-ci à l'aide des moto vannes (39, 49) laisse entrevoir des possibilités d'optimisation du fonctionnement des CEP.

Bien entendu, le mode de réalisation décrit ci-dessus, en référence aux figures relativement schématiques, n'est nullement limitatif. Des modes de réalisation sensiblement différents pouvant être mis au point sans sortir du cadre de la présente invention définie par les revendications ci-jointes.

## Revendications

1. Pompe à chaleur réversible destinée à être raccordée :
- à un premier circuit pour échanger de la chaleur avec l'intérieur d'un local et dans lequel circule un premier fluide ;
- à un deuxième circuit pour échanger de la chaleur avec l'extérieur et dans lequel circule un deuxième fluide ; et
- à une source de courant électrique,
ladite pompe à chaleur comprenant :
- une première conduite aller (11) et une première conduite retour (12) présentant chacune une première extrémité (11a, 12a) destinée à être raccordée au premier circuit d'échange de chaleur, et une deuxième extrémité ;
- une deuxième conduite aller (21) et une deuxième conduite retour (22) présentant chacune une première extrémité (21a, 22a) destinée à être raccordée au deuxième circuit d'échange de chaleur, et une deuxième extrémité ;
- au moins une unité thermoélectrique de transfert de chaleur (50) comprenant un premier et un deuxième échangeur (51, 52) ainsi qu'un nombre déterminé de modules thermoélectriques (53) adaptés pour transférer de la chaleur entre les premier et deuxième échangeurs ;
- une unité d'alimentation électrique (60) adaptée pour alimenter ladite au moins une unité thermoélectrique à partir de la source de courant électrique ;
- un boîtier (2) comprenant un châssis et des panneaux d'habillage à l'intérieur duquel sont logés les éléments de ladite pompe à chaleur,
**caractérisée en ce que** les premières et deuxièmes conduites aller et retour (11, 12, 21, 22) sont rigides et reliées de manière fixe par rapport à un socle (4) pour former au moins une partie du châssis (10),
ledit châssis portant des premiers et deuxièmes collecteurs aller et retour (31, 32, 41, 42) qui sont montés de manière amovible respectivement sur les deuxièmes extrémités (11b, 12b, 21b, 22b) des premières et deuxièmes conduites aller et retour,
lesdits premiers et deuxièmes collecteurs aller et retour présentant chacun au moins un connecteur (43) adapté pour relier de manière amovible et supporter fixement ladite au moins une unité thermoélectrique (50), les premiers collecteurs aller et retour assurant la circulation du premier fluide dans le premier échangeur (51) de ladite au moins une unité, et les deuxièmes collecteurs aller et retour assurant la circulation séparée du deuxième fluide dans le deuxième échangeur (52).

2. Pompe à chaleur selon la revendication précédente, dans laquelle chacun des connecteurs (43) des premiers et deuxièmes collecteurs aller et retour est portés par un élément modulaire identique (45) à travers lequel circule l'un des premier et deuxième fluides, la distance (p) séparant les connecteurs respectifs de deux éléments modulaires assemblés étant supérieure à l'espacement nécessaire entre deux unités thermoélectriques (50).

3. Pompe à chaleur selon l'une des revendications précédentes, dans laquelle les deuxièmes extrémités (11b, 12b, 21b, 22b) de chacune des premières et deuxièmes conduites aller et retour, sont agencées à des hauteurs différentes par rapport a un plan de référence de manière à ce que ladite au moins une unité thermoélectrique (50) reliée aux dites deuxièmes extrémités par des collecteurs identiques (31, 32, 41, 42), soit parallèle audit plan de référence.

4. Pompe à chaleur selon la revendication précédente, dans laquelle le plan de référence est déterminé de manière à ce que ladite au moins une unité thermoélectrique (50) présente une face supérieure globalement inclinée d'un angle compris entre 30 et 70 degrés par rapport à l'horizontale définie par le socle (4).

5. Pompe à chaleur selon l'une des revendications précédentes, dans laquelle les deuxièmes extrémités (11b, 12b, 21b, 22b) des premières et deuxièmes conduites aller et retour présentent une ouverture orientée vers le haut, les premier et deuxième collecteurs aller et retour (31, 32, 41, 42) s'étendant verticalement à partir de chacune de ces deuxièmes extrémités.

6. Pompe à chaleur selon l'une des revendications précédentes, dans laquelle les premier et deuxième échangeurs (51, 52) de ladite au moins une unité thermoélectrique (50) sont sensiblement identiques, de forme globalement parallélépipédique, et présentent des entrées et sorties de fluide sur des faces latérales opposées.

7. Pompe à chaleur selon l'une des revendications précédentes, dans laquelle ladite au moins une unité thermoélectrique (50) comprend un isolant (54) disposé entre les premier et deuxième échangeurs (51, 52), et présentant des fenêtres de dimensions correspondant aux modules thermoélectriques (53), lesdits modules thermoélectriques étant en contact direct avec les premier et les deuxième échangeurs à travers lesdites fenêtres.

8. Pompe à chaleur selon l'une des revendications précédentes, dans laquelle l'unité d'alimentation électrique (60) est placée dans la partie haute du boîtier (2), au-dessus de ladite au moins une unité thermoélectrique.

9. Pompe à chaleur selon l'une des revendications précédentes, dans laquelle une pluralité d'unités thermoélectriques (50) identiques est supportée fixement par les premier et deuxième collecteurs aller et retour (31, 32, 41, 42).

10. Pompe à chaleur selon la revendication précédente, dans laquelle l'unité d'alimentation électrique (60) comporte une pluralité de fiches électriques (63) susceptibles de délivrer chacune un courant d'alimentation pour une unité thermoélectrique (50), le nombre de fiches électriques étant égal au nombre maximal d'unités thermoélectriques susceptibles d'être logées dans le boîtier (2).

11. Pompe à chaleur selon la revendication 9 ou 10, dans laquelle l'unité d'alimentation électrique (60) comprend un dispositif de commande (65) adapté pour commander sélectivement la délivrance d'un courant d'alimentation à des unités thermoélectriques déterminées parmi la pluralité d'unités (50).

12. Pompe à chaleur selon la revendication précédente, dans laquelle au moins une paire de connecteurs (43) des premiers et deuxièmes collecteurs (31, 32, 41, 42) comporte une moto-vanne (39, 49) pour fermer sélectivement la circulation des premier et deuxième fluides dans une unité thermoélectrique déterminé (50), le dispositif de commande (65) étant de préférence adapté pour commander la fermeture des moto-vannes d'une unité thermoélectrique non alimentés électriquement.

13. Gamme de pompes à chaleur réversibles selon l'une quelconques des revendications précédentes, dans laquelle chaque modèle de la gamme comprend un châssis (10) et au moins une unité thermoélectrique (50) identiques, le nombre d'unités thermoélectriques (50) étant différent d'un modèle à l'autre de la gamme, et de préférence compris entre trois et douze pour une puissance de chauffage maximale comprise entre 1,5 Kw et 6 Kw.
